Europäisches Patentamt

European Patent Office

Office européen des brevets

(11) Publication number: **0 547 281 A1**

## EUROPEAN PATENT APPLICATION

(21) Application number: **91810985.1**

(22) Date of filing: **17.12.91**

(51) Int. Cl.5: **H01S 3/02**, H01L 33/00

(43) Date of publication of application:
**23.06.93 Bulletin 93/25**

(84) Designated Contracting States:
**DE FR GB IT**

(71) Applicant: **INTERNATIONAL BUSINESS MACHINES CORPORATION**

**Armonk, NY 10504(US)**

(72) Inventor: **Deutsch, Urs**
**Holzbirrliweg 13**
**CH-8802 Kilchberg(CH)**

(74) Representative: **Barth, Carl Otto**
**IBM Corporation Säumerstrasse 4**
**CH-8803 Rüschlikon (CH)**

(54) **Recessed ridge diode structure.**

(57) The present Application concerns an inventive ridge protection scheme which requires very moderate additional processing and still maintains the key advantage of the ridge structure namely the simplicity and single-step epitaxial growth. The present structure with recessed ridge waveguide reduces handling damage at wafer, bar and chip level. To achieve protection of the ridge, the whole structure, e.g. a laser diode- or a light emitting diode (LED) structure, with ridge waveguide, is grown on top of a structured substrate.

FIG. 3

EP 0 547 281 A1

## TECHNICAL FIELD

The present invention concerns a ridge waveguide diode structure, e.g. a laser or light emitting diode, with recessed ridge and a method for making the same.

## BACKGROUND OF THE INVENTION

The different lasers known to date can in general be classified into two groups, gain-guided and index-guided. In the gain-guided structure, the width of the optical mode along the junction plane is mainly determined by the width of the optical gain region, which in turn is determined by the width of the current-pumped region. In index-guided lasers a narrow central region of relatively higher refractive index in the junction plane confines the lasing mode to that region. These index-guided lasers can be divided into two general subgroups, weakly index guided and strongly index guided lasers. In weakly index guided lasers, the active region is continuous and the effective index discontinuity is provided by a cladding layer of varying thickness. By contrast, the strongly index guide lasers employ a buried heterostructure.

A wide variety of weakly index guided laser structures, which are easy to fabricate and very reliable, are known in the art. In addition these index guided lasers have a lower threshold current than gain-guided lasers. Depending on the specific design, these structures are known under various names, such as rib waveguide, ridge waveguide, plano-convex waveguide, and channeled-substrate planar waveguide.

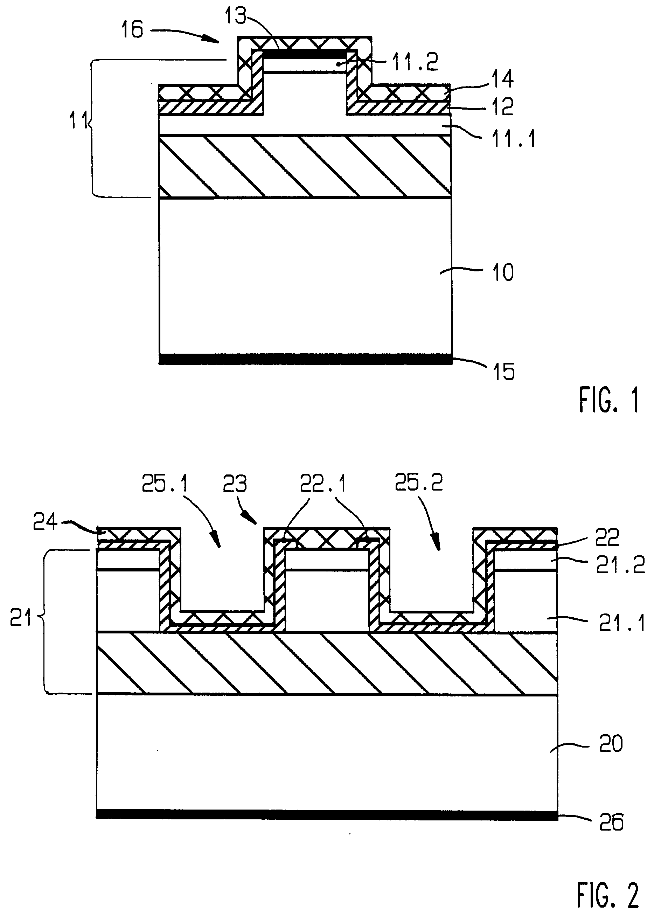

The ridge waveguide structure, in which the use of dielectric around the ridge, as shown in Figures 1 and 2, inhibits current spreading in the layers of the ridge, has been extensively studied. Laser diodes as well as light emitting diodes are known in the art employing a ridge waveguide. This structure offers different well known advantages in comparison to other structures. One disadvantage is that the ridge, which is the uppermost part of the whole structure, offers a great potential for damage due to wafer/bar/chip handling. Pressure on the ridge or even damage of the ridge has a strong influence on the diodes performance as well as yield. A simple ridge protection means would reduce the probability of damage and improve the reliability.

Two different, elementary ridge structures are illustrated in Figures 1 and 2. As can be seen from Figure 1, which shows a widely used ridge structure, the ridge is very exposed such that a manipulator, for example used during the packaging of the diode, could damage the ridge 16. The structure shown in Figure 2, called channeled ridge structure, is causing less potential for damage because its ridge 23 has the same height than the surrounding surfaces. Typical laser diodes with ridge structure are reported on in the following articles:

- "Transverse-Mode" Control in an Injection Laser by a Strip-Loaded Waveguide", H. Kawaguchi et al., IEEE Journal of Quantum Electronics, Vol. QE-13, No. 8, August 1977, pp. 556 - 560;
- "New Stripe-Geometry Laser with Simplified Fabrication Process", M.-C. Amann, Electronics Letters, July 1979, Vol. 15, No. 14, pp. 441 - 442;
- "Performance of an Improved InGaAsP Ridge Waveguide Laser at 1.3 $\mu$m", I.P. Kaminow et al., Electronic Letters, April 1981, Vol. 17, No. 9, pp. 318 - 320;
- "Low-Threshold InGaAsP Ridge Waveguide Lasers at 1.3 $\mu$m", I.P. Kaminow et al., IEEE Journal of Quantum Electronics, Vol. QE-19, No. 8, August 1983, pp. 1312 - 1318;
- "Very Low Threshold Current Ridge-Waveguide AlGaAs/GaAs Single-Quantum-Well Lasers", O. Wada et al., Electronics Letters, Vol. 21, No. 22, October 1985, pp. 1025 - 1026;
- "Single-Mode C.W. Ridge Waveguide Laser Emitting at 1.55 $\mu$m", I.P. Kaminow et al., Electronics Letters, November 1979, Vol. 15, No. 23, pp. 763 - 765;
- European Patent Application with Publication Number 0 426 419, (in particular Figure 5).

No prior art is known, which efficiently reduces the probability of mechanical damage and does not require additional complicated and expensive steps to achieve an efficient ridge protection scheme for laser diodes and light emitting diodes,

## SUMMARY OF THE INVENTION

The main object of this invention is to provide a ridge protection scheme which is simple to implement and does not influence the performance of the ridge waveguide diode.

Another object of the invention is to provide a ridge protection scheme which requires very moderate additional processing steps during the fabrication of the ridge waveguide diode.

A further object is to provide for a structure and a method for making the same which can be employed in various ridge waveguide devices.

This has been achieved by employing a structured substrate, instead of a conventional planar substrate, which has a groove with a depth greater than the height of the ridge to be defined on this structured substrate. The formation of this groove only requires a photolithographic step followed by an etch step prior to the well known fabrication steps of conventional ridge structures. The key advantages of the inventive structure with recessed ridge are their simplicity and the single-step epitaxially growth.

## DESCRIPTION OF THE DRAWINGS

The invention is described in detail below with reference to the following drawings which are schematic and not drawn to scale, while more particularly the thickness of cross-sectional shown semiconductor layers are exaggerated for the sake of clarity.

FIG. 1        is a cross-section of a conventional ridge waveguide diode.

FIG. 2        is a cross-section of a conventional channeled ridge waveguide diode.

FIG. 3 a)-g)  shows the different fabrication steps of a structure with recessed ridge waveguide, in accordance with the present invention.

FIG. 4 a)-d)  are cross-sections of four different ridge waveguide structures.

FIG. 5        is a schematic cross-section of a structured substrate in accordance with the present invention.

## GENERAL DESCRIPTION

A conventional ridge waveguide diode, as illustrated in Figure 1, and described in the article "Very Low Threshold Current Ridge-Waveguide AlGaAs/GaAs Single-Quantum-Well Lasers", written by O. Wada et al., and published in Electronics Letters, Vol. 21, No. 22, October 1985, pp. 1025 - 1026, is grown on a substrate 10 and comprises a sequence of stacked layers 11. The upper layers 11.1 and 11.2 of these stacked layers 11, are etched such that a ridge 16 is defined. The etched horizontal surface of layer 11.1, surrounding said ridge 16, and the sidewalls of ridge 16 are covered by an insulator 12, and the top surface of ridge 16 is connected via a metallization layer 13 to the top electrode 14. The metallization 15, on the backside of substrate 10, serves as bottom electrode.

Another structure, with channeled ridge waveguide, is shown in Figure 2 and reported on in the article "Single-Mode C.W. Ridge Waveguide Laser Emitting at 1.55 $\mu$m", I.P. Kaminow et al., Electronics Letters, November 1979, Vol. 15, No. 23, pp. 763 - 765. This structure is made by growing stacked layers 21 on top of a substrate 20 and forming two channels 25.1 and 25.2 parallel to ridge 23. These channels are etched into the upper layers 21.1 and 21.2 of the stacked layers 21. After this etch step, the entire upper surface was covered by an insulation layer 22 and a small contact window has been etched into this insulating layer 22 on top of the ridge 23. This window is centered on the ridge such that the edges of the ridge remain covered by the insulator 22.1. A metallization layer 24 covers the entire surface of the structure and serves as upper electrode of the diode. The backside of substrate 20 is covered by metallization layer 26 serving as bottom contact. As can be seen from the cross-section in Figure 2, the ridge 23 has the same height than the surrounding surfaces. The fabrication of this channeled structure is more complicated than the conventional ridge waveguide structure and in addition is not well suited for the use in closely spaced laser arrays.

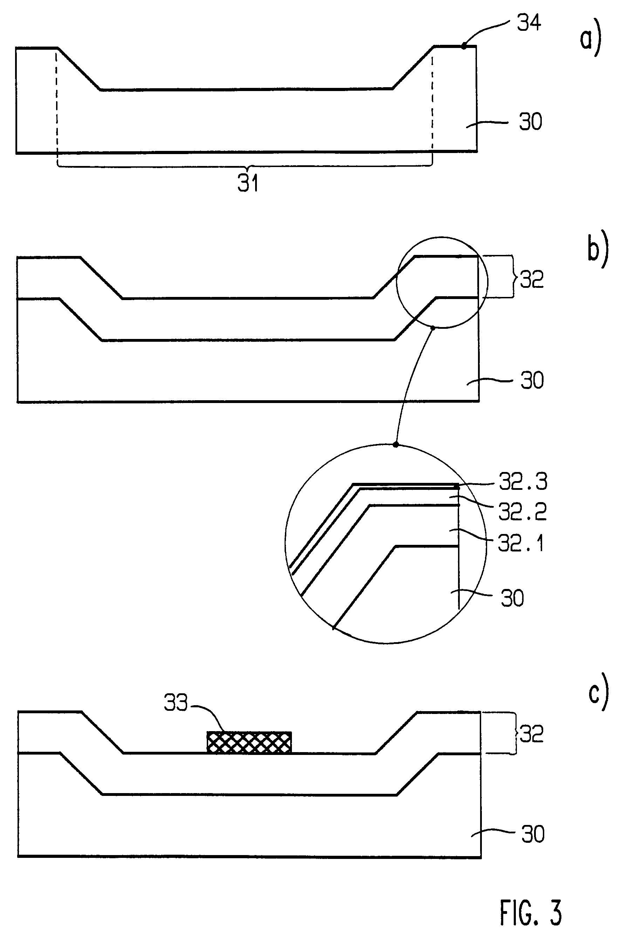

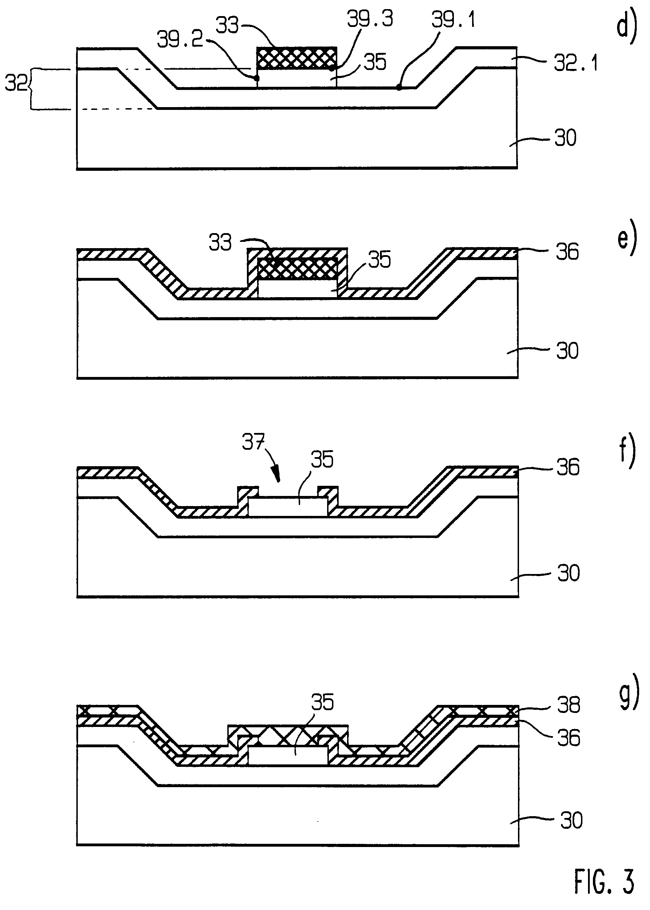

The principle of the present invention is described in connection with the sequence of processing steps shown in Figure 3 a) - g). Instead of epitaxially growing the sequence of stacked layers on top of an unstructured substrate, see reference number 10 in Figure 1, the inventive ridge waveguide is formed on top of a substrate 30 with a groove 31. This groove can be made using a photolithographic step followed by an etch step. The sidewalls of groove 31, shown in Figure 3 a), are inclined since the groove is made using a wet-etch technique. Instead of wet-etching a dry-etch process could be used. After the definition of groove 31, follows the one-step epitaxially growth of a sequence of stacked layers 32. These layers can be grown using a conventional Liquid Phase Epitaxy (LPE). The stacked layers 32 are grown such that they at least partly cover the groove 31 and the surrounding surface 34 of the substrate 30. A magnified sketch of these stacked layers 32 is shown in Figure 3 b). The sequence of stacked layers consists of an active region 32.1, comprising several layers which are not shown, and two upper layers 32.2 and 32.3. The following steps are well known in the art and are not described with all details. Next, the ridge has to be defined using a photolithographic step. A mask 33, produced by development of a photoresist, is situated on top of the sequence of stacked layers 32 and above said groove 31, as illustrated in Figure 3 c). The ridge is now defined by using selective etchants such that only the upper layers of the sequence of stacked layers 32, for example layers 32.2 and 32.3, are etched. The thickness of the stacked layers 32 is now reduced and only the remaining portion of said stacked layers, e.g. active region 32.1, covers the entire groove 31 and surrounding surface 34, as shown in Figure 3 d). During the next step. shown in Figure 3 e), the entire structure is covered by an insulating layer 36. Care has to be taken that especially the horizontal surface 39.1 of the groove, and the sidewalls 39.2 of the ridge, are covered. The top surface 39.3 of the ridge remains covered by the mask 33. In the following the structure is rinsed in a solution such that the mask 33, and the covering insulator 36 on top, are removed. As shown in Figure 3 f), a contact window 37 is opened during this step. This step for the definition of contact window 37 is followed by well known steps for electrically contacting the ridge 35. As simplified shown in Figure 3 g), this has been achieved by depositing a metallization layer 38, which covers the entire surface of the structure with recessed waveguide. As can be seen from the last Figure of this sequence of Figures, the ridge waveguide 35 of the inventive structure is recessed relative to the surrounding surfaces.

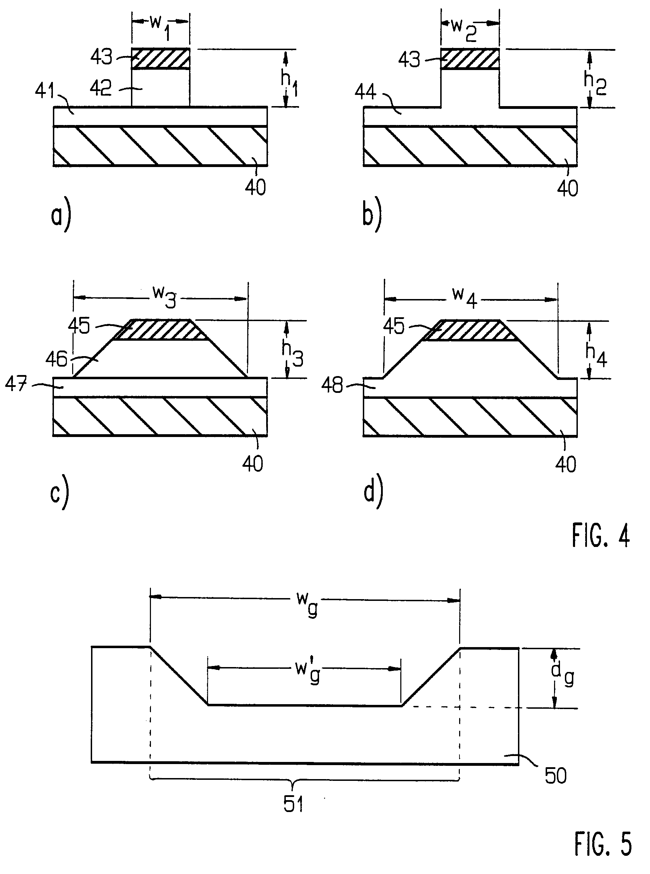

Four schematic cross-sections of typical ridge waveguide structures are illustrated in Figures 4 a) - d). The ridge structure, shown in Figure 4 a), has a buffer layer 41 grown on top of an active region 40. This active region 40 may for example comprise an active layer embedded between two cladding layers or a quantum well structure. The ridge consists of two layers 42 and 43, layer 42 serving as cladding layer and layer 43 as cap layer. This cap layer 43 may be doped by diffusion of dopants into this layer after definition of the ridge. The ridge has been defined by etching the upper two layers 43 and 42 down to layer 41. Selective etching results in a well defined height $h_1$ of the ridge, since the etching process stops at layer 41. The width $w_1$ of this ridge depends on the size and quality of the mask and the etch technique used for its definition. Comparable structures are reported on in the publications "Transverse-Mode Control in an Injection Laser by a Strip-Loaded Waveguide", H. Kawaguchi et al., IEEE Journal of Quantum Electronics, Vol. QE-13, No. 8, August 1977, pp. 556 - 560, and "Performance of an Improved In-GaAsP Ridge Waveguide Laser at 1.3 $\mu$m", I.P. Kaminow et al., Electronic Letters, April 1981, Vol. 17, No. 9, pp. 318 - 320.

Another ridge waveguide structure, having a cladding layer 44 with varying thickness grown on an active region 40, is illustrated in Figure 4 b). There is no etch-stop layer at which a selective etch process automatically stops. The etch depth has to be determined by taking into account the etch rate of the respective material and interrupting the etch process at the right time. There are some uncertainties with regard to the reproducibility and the exact definition of the height $h_2$ and width $w_2$ of the ridge. An exemplary structure is described in "Very Low Threshold Current Ridge-Waveguide AlGaAs/GaAs Single-Quantum-Well Lasers", O. Wada et al., Electronics Letters, Vol. 21, No. 22, October 1985, pp. 1025 - 1026.

The structures shown in Figures 4 c) and 4 d) are similar to the structures shown above, with the difference that they are made using wet-etch techniques. This results in ridges having typical inclined sidewalls. The width of these ridges has to be measured at the base of the ridge, where the width has its maximum, as indicated by $w_3$ and $w_4$. A well known ridge waveguide structure with inclined sidewalls and fabrication of the same are reported on in the article "High-Power Ridge-Waveguide AlGaAs GRIN-SCH Laser Diode", C. Harder et al., Electronics Letters, September 1986, Vol. 22, No. 20, pp. 1081 - 1082.

A structured substrate 50, on which the sequence of stacked layers of a ridge waveguide structure can be grown, in accordance with the present invention, is shown in Figure 5. The groove 51, etched into substrate 50 by using either a wet-etch or a dry-etch technique has a depth $d_g$, a width $w'_g$ at the bottom, and a width $w_g$ at the top. The difference $\Delta w = w_g - w'_g$ depends on the etch technique and mask used for the definition of the groove. The width $w'_g$ has to be greater than the maximum width of the ridge which has to be formed in this groove, as shown in equation (1):

$$w'_g > w_n \text{ with } n = 1,2,3 \text{ or } 4 \qquad (1)$$

The depth $d_g$ of the groove has to be at least

$$d_g > h_n \text{ with } n = 1,2,3 \text{ or } 4 \qquad (2)$$

to ensure an efficient protection of the ridge, in accordance with the present invention.

The advantages of the present invention are obvious; the inventive structure, with recessed ridge waveguide, does only require simple steps for the definition of the groove, such as for example a photolithographic step to form a mask which covers the substrates surface and which provides for an etch window through which the groove can be etched. The following steps for the fabrication of the ridge structure are not affected by this. The ridge protection scheme can be employed for the fabrication of various ridge waveguide structures known in the art. Further advantages of the inventive structures are that they neither require complicated and complex alignment steps nor require an interrupt of the one-step epitaxial growth of the sequence of stacked layers. In addition, the inventive structures can be made of different materials such as III-V and II-VI semiconductors. Arrays of light emitting diodes as well as arrays of laser diodes can be made having recessed ridges by defining one groove per diode or a wider groove for multiple diodes.

**Claims**

1. Light producing ridge waveguide semiconductor diode, comprising stacked layers (32; 40 - 43; 40, 44, 43; 40, 45 - 47; 40, 48, 45) grown on a substrate (30; 50), a ridge waveguide (35) with sidewalls (39.2), a top surface (39.3), and a horizontal surface surrounding said ridge (35), and an insulating layer (36) at least covering said sidewalls (39.2) and said horizontal surface, characterized in that,
   - said substrate (30; 50) has a groove (31: 51) with a depth being greater than the height of said ridge (35);
   - said stacked layers (32; 40 - 43; 40, 44, 43; 40, 45 - 47; 40, 48, 45) overlap said groove (31; 51) and at least partly the substrate's surface (34) surrounding said groove (31; 51),
   - said ridge waveguide (35) is defined by etching a part of said stacked layers (32.3, 32.2; 43, 42; 43, 44; 45, 46; 45, 48) above said groove (31; 51), such that the uppermost part of the ridge waveguide (35) is recessed with respect to the uppermost part of the structure surrounding said groove (31; 51).

2. The diode of claim 1, characterized in that said ridge has a height $h_n$ and said groove has a depth $d_g$ such that $d_g > h_n$.

3. The diode of claim 1 or 2, characterized in that said groove (31; 51) has a width $w'_g$ which is greater than the width $w_n$ at the basis of said ridge ($w'_g > w_n$).

4. The diode of any preceding claim, characterized in that said diode is a laser diode.

5. The diode of any of the claims 1 or 2 or 3, characterized in that said diode is a light emitting diode.

6. The diode of claim 4, characterized in that said stacked layers comprise an active region (40), a buffer layer (41; 47), a cladding layer (42; 46), and a cap layer (43; 45), said cladding layer (42; 46) and said cap layer (43; 45) being part of said ridge waveguide.

7. The diode of claim 4, characterized in that said stacked layers comprise an active region (40), a cladding layer (44; 48), and a cap layer (43; 45), a part of said cladding layer (44; 48) and said cap layer (43; 45) being part of said ridge.

8. The diode of claim 6 or 7, characterized in that said active region (40) comprises an active layer, in. particular an active layer embedded between two cladding layers.

9. The diode of claim 6 or 7, characterized in that said active region (40) comprises a quantum well structure.

10. The diode of claim 1, characterized in that said groove (31; 51) has either vertical or inclined sidewalls.

11. Method for making a light producing ridge waveguide semiconductor diode having stacked layers (32; 40 - 43: 40, 44, 43; 40, 45 - 47; 40, 48, 45) grown on a substrate (30; 50), a ridge waveguide (35) with sidewalls (39.2), a top surface (39.3), and a horizontal surface surrounding said ridge (35), and an insulating layer (36) at least covering said sidewalls (39.2) and said horizontal surface, comprising the following steps:
   - defining a groove (31; 51) in said substrate (30; 50) with a depth being greater than the height of said ridge (35) to be formed
   - sequentially depositing said stacked layers (32; 40 - 43; 40, 44, 43; 40, 45 - 47; 40, 48, 45) on said substrate (30; 50) such that they cover said groove (31; 51) and at least a part of the substrate's surface (34) surrounding said groove (31; 51),
   - defining the ridge waveguide (35) in the stacked layers (32.3, 32.2; 43, 42; 43, 44; 45, 46; 45, 48) above said groove (31; 51) such that the ridge waveguide (35) is situated in said groove (31; 51) and the uppermost part of the ridge (35) is recessed with respect to the uppermost part of the structure surrounding said groove (31; 51).

12. Method of claim 11, characterized in that the groove (31; 51) is defined by photolithographically forming a mask which has a window, and etching said groove (31; 51) through the window of said mask.

FIG. 1

FIG. 2

a)

34

30

31

b)

32

30

32.3
32.2
32.1

30

c)

33

32

30

FIG. 3

EP 0 547 281 A1

FIG. 3

FIG. 4

FIG. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | JP-A-51 138 393 (FUJITSU KK)<br>* figures *<br>& PATENT ABSTRACTS OF JAPAN<br>vol. 1, no. 41 (E-015)22 April 1977<br>* abstract *<br>--- | 1-12 | H01S3/02<br>H01L33/00 |
| X | JP-A-51 138 394 (FUJITSU KK)<br>* figures *<br>& PATENT ABSTRACTS OF JAPAN<br>vol. 1, no. 41 (E-015)22 April 1977<br>* abstract *<br>--- | 1-12 | |
| A | PATENT ABSTRACTS OF JAPAN<br>vol. 14, no. 133 (E-902)13 March 1990<br>& JP-A-2 000 394 ( CANON )<br>* abstract *<br>--- | 1,4,6,7,9 | |
| A | PATENT ABSTRACTS OF JAPAN<br>vol. 12, no. 322 (E-652)31 August 1988<br>& JP-A-63 086 581 ( SHIMADZU )<br>* abstract *<br>--- | 1,5 | |
| A | PATENT ABSTRACTS OF JAPAN<br>vol. 13, no. 251 (E-771)12 June 1989<br>& JP-A-1 050 591 ( MITSUBISHI )<br>* abstract *<br>----- | 1,11 | TECHNICAL FIELDS SEARCHED (Int. Cl.5)<br><br>H01S<br>H01L |

The present search report has been drawn up for all claims

| Place of search | Date of completion of the search | Examiner |
|---|---|---|
| THE HAGUE | 22 JULY 1992 | CLAESSEN L.M. |

EPO FORM 1503 03.82 (P0401)